(19) Europäisches Patentamt
European Patent Office
Office européen des brevets

(11) **EP 4 675 213 A1**

(12) **EUROPEAN PATENT APPLICATION**
published in accordance with Art. 153(4) EPC

(43) Date of publication:
**07.01.2026 Bulletin 2026/02**

(21) Application number: **24763772.1**

(22) Date of filing: **22.02.2024**

(51) International Patent Classification (IPC):
**F28D 15/02** (2006.01)   **H01L 23/427** (2006.01)
**H05K 7/20** (2006.01)

(52) Cooperative Patent Classification (CPC):
**F28D 15/02; H01L 23/427; H05K 7/20**

(86) International application number:
**PCT/JP2024/006484**

(87) International publication number:
**WO 2024/181291 (06.09.2024 Gazette 2024/36)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.02.2023 JP 2023029356**

(71) Applicant: **Kyocera Corporation
Kyoto-shi, Kyoto 612-8501 (JP)**

(72) Inventor: **KONISHI, Yoshitada
Kyoto-shi, Kyoto 612-8501 (JP)**

(74) Representative: **Viering, Jentschura & Partner
mbB
Patent- und Rechtsanwälte
Am Brauhaus 8
01099 Dresden (DE)**

(54) **HEAT DISSIPATION MEMBER AND VAPOR CHAMBER**

(57)     A heat dissipation member includes a substrate including a first surface, and a housing including a recess and a second surface positioned around an opening end of the recess. The second surface is bonded to the first surface. The recess includes, inside the recess, a space surrounded by the housing and the substrate. In the vertical section, a side-wall inner surface of the space has a recessed, curved shape, and a side-wall outer surface of the housing has a recessed, curved shape. In the vertical section, a recessed direction of the side-wall inner surface and a recessed direction of the side-wall outer surface are opposed to one another.

FIG. 2

Description

TECHNICAL FIELD

The present disclosure relates to a heat dissipation member and a vapor chamber.

BACKGROUND OF INVENTION

Japanese Unexamined Patent Application Publication No. 2003-254685 discloses a vapor chamber including a flat internal space.

SUMMARY

SOLUTION TO PROBLEM

According to the present disclosure, a heat dissipation member includes a substrate and a housing. The substrate includes a first surface. The housing includes a recess and a second surface positioned around an opening end of the recess. The second surface is bonded to the first surface. The recess includes, inside the recess, a space surrounded by the housing and the substrate. In the vertical section, a side-wall inner surface of the space has a recessed, curved shape, and a side-wall outer surface of the housing has a recessed, curved shape. In the vertical section, a recessed direction of the side-wall inner surface and a recessed direction of the side-wall outer surface are opposed to one another.

According to the present disclosure, a vapor chamber includes the heat dissipation member and liquid-phase fluid in the space.

BRIEF DESCRIPTION OF THE DRAWINGS

FIG. 1A is a vertical sectional view of a heat dissipation member and a vapor chamber according to Embodiment 1 of the present disclosure.
FIG. 1B is a plan view of the heat dissipation member and the vapor chamber according to Embodiment 1 of the present disclosure.
FIG. 2 is a vertical sectional view of a side wall part of the heat dissipation member in FIG. 1A.
FIG. 3A is a vertical sectional view of a side wall part of a heat dissipation member according to Embodiment 2.
FIG. 3B is a vertical sectional view of a side wall part of a heat dissipation member according to Embodiment 3.
FIG. 3C is a vertical sectional view of a side wall part of a heat dissipation member according to Embodiment 4.
FIG. 3D is a vertical sectional view of a side wall part of a heat dissipation member according to Embodiment 5.

FIG. 4A is a vertical sectional view of a side wall part of a heat dissipation member according to Embodiment 6.
FIG. 4B is a vertical sectional view of a side wall part of a heat dissipation member according to Embodiment 7.
FIG. 5A is a vertical sectional view of a side wall part of a heat dissipation member according to Embodiment 8.
FIG. 5B is a vertical sectional view of a side wall part of a heat dissipation member according to Embodiment 9.
FIG. 6A is a vertical sectional view of a side wall part of a heat dissipation member according to Embodiment 10.
FIG. 6B is a vertical sectional view of a side wall part of a heat dissipation member according to Embodiment 11.
FIG. 6C is a vertical sectional view of a side wall part of a heat dissipation member according to Embodiment 12.
FIG. 6D is a vertical sectional view of a side wall part of a heat dissipation member according to Embodiment 13.
FIG. 6E is a vertical sectional view of a side wall part of a heat dissipation member according to Embodiment 14.
FIG. 7 is a graph illustrating values of parameters of the heat dissipation members according to Embodiments 10 to 14.
FIG. 8 is a vertical sectional view of a side wall part of a heat dissipation member according to Embodiment 15.
FIG. 9 is a vertical sectional view of a side wall part of a heat dissipation member according to Embodiment 16.
FIG. 10A is a perspective view of a part of interest, illustrating a corner-part outer side of a housing according to Embodiments 17 and 18.
FIG. 10B is a perspective view including a vertical section of a part of interest, illustrating a corner-part inner side of the housing according to Embodiment 17.
FIG. 10C is a perspective view including a vertical section of a part of interest, illustrating a corner-part inner side of the housing according to Embodiment 18.

DESCRIPTION OF EMBODIMENTS

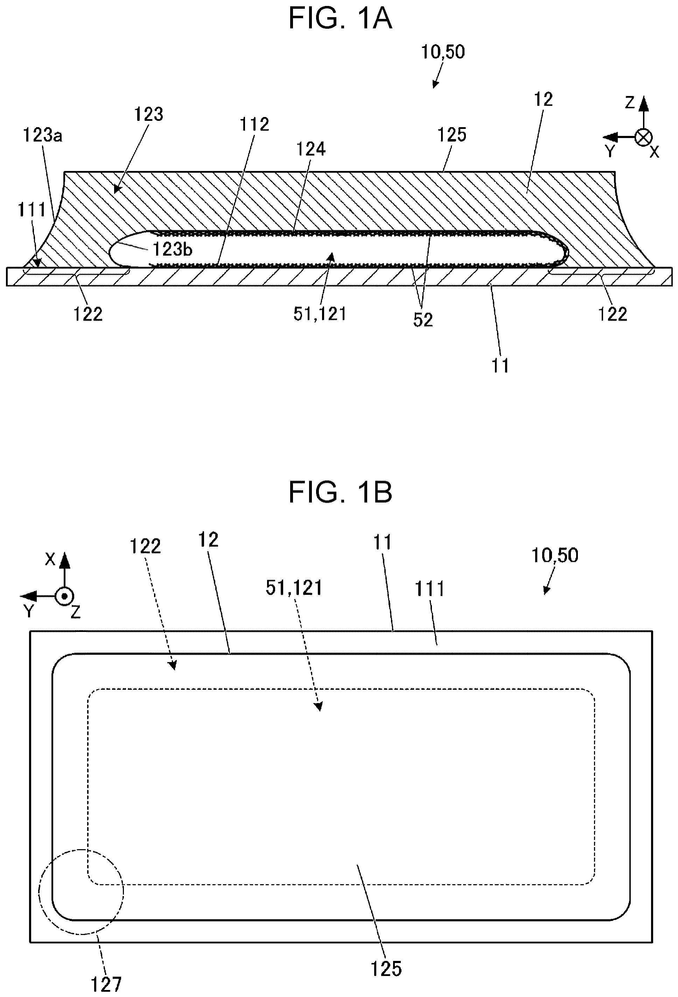

Hereinafter, an embodiment of the present disclosure is described in detail with reference to the drawings. In the following description, a direction along an X-Y plane in FIG. 1 is assumed to be a horizontal direction, and a Z-direction in FIG. 1 is assumed to be an upper direction. However, the respective directions do not necessarily match directions in use of a heat dissipation member 10 or a vapor chamber 50.

(Embodiment 1)

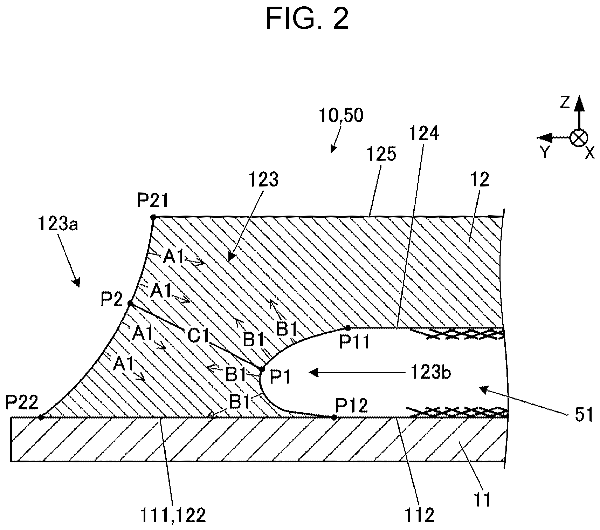

FIGs. 1A and 1B are respectively a vertical sectional view and a plan view of a heat dissipation member and a vapor chamber according to Embodiment 1 of the present disclosure. FIG. 2 is a vertical sectional view of a side wall part of the heat dissipation member in FIG. 1A.

The vapor chamber 50 in Embodiment 1 includes the heat dissipation member 10 including a space 51 therein, and liquid-phase fluid in the space 51. The space 51 may be sealed and depressurized. The liquid-phase fluid may employ water, acetone, methanol, ammonia, or the like. With such a configuration, upon application of heat to any portion of the heat dissipation member 10 and dissipation of heat from another portion of the heat dissipation member 10, liquid-phase fluid undergoes phase transition (that is, vaporization and condensation) inside the space 51. In addition, liquid-phase fluid and gas-phase fluid obtained thorough vaporization of the liquid-phase fluid are refluxed in the space 51. Such an action enables prompt heat dissipation of the above-described heat.

The heat dissipation member 10 includes a substrate 11 including a first surface 111, a housing 12 including a second surface 122, and a void structure 52. A heat source may be mounted on an external top surface (corresponding to a third surface) 125 of the housing 12, and a heat dissipation member may be attached to a lower surface of the substrate 11. The heat source may be an electronic element. The heat dissipation member may be a heat dissipation block, a substrate with a heat dissipation action (for example, a module substrate), or the like.

The substrate 11 may have a plate-like shape. The substrate 11 may include ceramic as a main constituent. The main constituent means a constituent that accounts for 80 mass% or more. The ceramic may be a material including, as a main constituent, silicon nitride ($Si_3N_4$), silicon carbide (SiC), mullite or aluminum nitride (AlN), aluminum oxide ($Al_2O_3$), or the like.

The housing 12 may include a recess 121 with an opening end facing downward. The second surface 122 may be positioned around the opening end of the recess 121. The second surface 122 may be positioned around an entire peripheral of the opening end.

The second surface 122 of the housing 12 may be bonded to the first surface 111 of the substrate 11. The recess 121 may include therein the space 51 surrounded by the housing 12 and the substrate 11. The second surface 122 and the first surface 111 may be bonded to one another with a bonding material, such as a brazing material, interposed therebetween.

The housing 12 may include a metal, such as copper, aluminum, titanium, nickel, stainless steel, or an iron alloy (for example, an Fe-Ni-Co alloy). The substrate 11 may include a metal the same as and/or similar to the metal for the housing 12. The substrate 11 and the housing 12 may include the same metal, or may include metals different from one another.

The void structure 52 is a structure including many fine voids. The void structure 52 may be a set of fibrous bodies, porous bodies, or needle-like bodies, or a net-like structure. The void structure 52 may be capable of holding and transferring liquid-phase fluid by surface tension.

The void structure 52 may be located at a side wall part 123, an internal top surface 124, an internal bottom surface 112, and/or the like of the space 51. Such arrangement enables smooth transfer of liquid-phase fluid by surface tension over a wide range in the space 51. Such transfer of liquid-phase fluid causes liquid-phase fluid and gas-phase fluid to circulate in the space 51, and improves heat dissipation capacity of the heat dissipation member 10.

On the other hand, the void structure 52 may have difficulty being arranged over an entire side wall part 123 of the space 51. If a portion of the side wall part 123 includes a region without the void structure 52, part of liquid-phase fluid easily stagnates at the side wall part 123. Stagnation of part of liquid-phase fluid reduces an amount of heat transfer by fluid by an amount of the stagnation, and the heat dissipation member 10 has reduced heat dissipation capacity.

In order to reduce stagnation of liquid-phase fluid as described above, the heat dissipation member 10 in Embodiment 1 may include a structure of the side wall part 123 as described below. That is, as illustrate in FIG. 2, in a vertical section of the heat dissipation member 10, a side-wall inner surface 123b of the space 51 may have a recessed, curved shape. In the same vertical section, a side-wall outer surface 123a of the housing 12 may have a recessed, curved shape. In addition, in the same vertical section, a recessed direction A1 of the side-wall inner surface 123b and a recessed direction B1 of the side-wall outer surface 123a may be opposed to one another.

The vertical section means a section substantially orthogonal to the first surface 111 and substantially orthogonal to a direction in which the side wall part 123 extends horizontally. As illustrated in FIG. 2, the side-wall inner surface 123b is a surface of the side wall part 123 closer to the space 51, and means a surface between an intersection point P11 of the sectionally linear internal top surface 124 and the side wall part 123, and an intersection point P12 of the sectionally linear internal bottom surface 112 and the side wall part 123. The side-wall outer surface 123a is an outer surface of the side wall part 123, and means a surface between an intersection point P21 of the sectionally linear external top surface 125 and the side wall part 123, and an intersection point P22 of the sectionally linear first surface 111 and the side wall part 123. The recessed direction A1, B1 means a direction to a recessed side and a direction perpendicular to a tangent line of a curve. The recessed direction is a direction with a range. One of the recessed directions and the other one of the recessed directions being opposed to one another means that any of the direction A1 and any of the direction B1 are directly opposed to one another within a margin of error. The error may be equal to or less than ±15°, or equal to or less than ±5°.

With the side wall part 123 described above, in the vertical section, the side wall part 123 includes a thicker portion and a thinner portion. Therefore, at the thinner portion, a heat dissipation amount from the side-wall inner surface 123b toward the side-wall outer surface 123a is large, and at the thicker portion, a heat dissipation amount from the side-wall inner surface 123b toward the side-wall outer surface 123a is comparatively small. In this manner, a heat dissipation amount has difference, that is, a gradient along the side-wall inner surface 123b. The gradient of a heat dissipation amount can facilitate transfer of liquid-phase fluid at the side-wall inner surface 123b. Therefore, liquid-phase fluid can have improved fluidity at the side-wall inner surface 123b, and liquid-phase fluid can be less likely to stagnate at the side-wall inner surface 123b. Accordingly, the heat dissipation member 10 can have further improved heat dissipation capacity.

The side wall part 123 of the heat dissipation member 10 may include the following structure. That is, in the vertical section, one end P1, closer to the side-wall inner surface 123b, of a line segment C1 may be positioned away from the intersection points P11 and P12 at both ends of the side-wall inner surface 123b. The line segment C1 connects the side-wall inner surface 123b and the side-wall outer surface 123a with a shortest line. In addition, the other end P2 of the line segment C1 closer to the side-wall outer surface 123a may be positioned away from the intersection points P21 and P22 at both ends of the side-wall outer surface 123a.

With such a configuration, the side wall part 123 includes a narrowed portion (that is, a thinnest portion at an intermediate position). Therefore, the side-wall inner surface 123b includes a portion with a larger heat dissipation amount and a portion with a smaller heat dissipation amount respectively at the narrowed portion and its periphery. The gradient of a heat dissipation amount facilitates transfer of liquid-phase fluid at the side-wall inner surface 123b. Thereby, liquid-phase fluid can have further improved fluidity at the side-wall inner surface 123b, and liquid-phase fluid can be less likely to stagnate at the side-wall inner surface 123b. Accordingly, the heat dissipation member 10 can have further improved heat dissipation capacity.

The heat dissipation member 10 may include the above-described structure of the side-wall outer surface 123a and the side-wall inner surface 123b over an entire peripheral of the side wall part 123 in plan view. Alternatively, only one side of the side wall part 123 in plan view, or only a partial range of the side wall part 123 may include the above-described structure of the side-wall outer surface 123a and the side-wall inner surface 123b. If a large range includes the above-described structure, a large range of the side wall part 123 can achieve the effect described above.

(Embodiments 2 to 5)

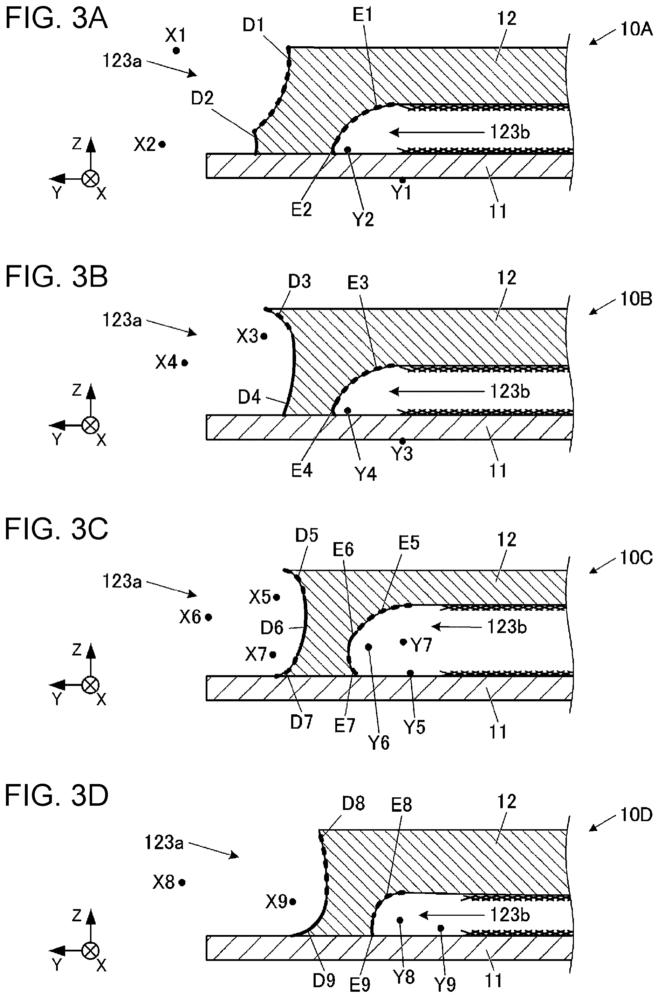

FIGs. 3A to 3D are vertical sectional views of side wall parts of heat dissipation members respectively according to Embodiments 2 to 5. Heat dissipation members 10A to 10D in Embodiments 2 to 5 may be the same as and/or similar to that in Embodiment 1 except for difference in a shape of the side wall part 123. Each of the heat dissipation members 10A to 10D in Embodiments 2 to 5 may be included in a vapor chamber in the same and/or similar manner as or to Embodiment 1.

In the vertical section, the side-wall outer surface 123a may be a surface including a plurality of recessed, arc-shaped curves combined. The plurality of arc-shaped curves may have radii the same as or different from one another.

In the vertical section, the side-wall inner surface 123b may be a surface including a plurality of recessed, arc-shaped curves combined. The plurality of arc-shaped curves may have radii the same as or different from one another.

The arc-shaped curve means a gentle curve with an error with respect to an arc at 5% or less of a diameter of the arc.

Specifically, in the vertical section, the side-wall outer surface 123a and the side-wall inner surface 123b may have shapes as in Embodiments 2 to 5 in FIGs. 3A to 3D. The side-wall outer surface 123a in FIG. 3A has a shape including two recessed, arc-shaped curves D1 and D2 combined. The side-wall inner surface 123b in FIG. 3A has a shape including two recessed, arc-shaped curves E1 and E2 combined. The side-wall outer surface 123a in FIG. 3B is a surface including arc-shaped curves D3 and D4 with different radii combined smoothly. Points X3 and X4 are center points of arcs along the respective ones of the curves D3 and D4. The side-wall inner surface 123b in FIG. 3B is a surface including arc-shaped curves E3 and E4 with different radii combined smoothly. Points Y3 and Y4 are center points of arcs along the respective ones of the curves E3 and E4. The side-wall outer surface 123a in FIG. 3C is a surface including three arc-shaped curves D5 to D7 combined smoothly. Points X5 to X7 are center points of arcs along the respective ones of the curves D5 to D7. The side-wall inner surface 123b in FIG. 3C is a surface including three arc-shaped curves E5 to E7 combined smoothly. Points Y5 to Y7 are center points of arcs along the respective ones of the curves E5 to E7. The side-wall outer surface 123a in FIG. 3D is a surface including arc-shaped curves D8 and D9 with different radii combined smoothly. Points X8 and X9 are center points of arcs along the respective ones of the curves D8 and D9. The side-wall inner surface 123b in FIG. 3D is a surface including arc-shaped curves E8 and E9 with different radii combined smoothly. Points Y8 and Y9 are center points of arcs along the respective ones of the curves E8 and E9.

The side-wall outer surface 123a in the shape as described above can improve fluidity of outside air along the side-wall outer surface 123a. Therefore, heat dissipation from the side wall part 123 improves, and an action by the narrowed portion of the side wall part 123 (that is, a gradient of a heat dissipation amount at the side-wall inner surface 123b) can further increase. The side-wall inner surface 123b in the shape as described above can reduce flow resistance of liquid-phase fluid and the gas-phase fluid at the side-wall inner surface 123b. Therefore, liquid-phase fluid can have further improved fluidity at the side-wall inner surface 123b, and liquid-phase fluid can be further less likely to stagnate at the side-wall inner surface 123b. Accordingly, the heat dissipation members 10A and 10D can have further improved heat dissipation capacity.

In the vertical section, if the side-wall outer surface 123a includes a plurality of arc-shaped curves, a curve having largest influence on heat dissipation characteristics among the plurality of arc-shaped curves is a longest curve portion. In the vertical section, if the side-wall inner surface 123b includes a plurality of arc-shaped curves, a curve having largest influence on liquid-phase fluid among the plurality of arc-shaped curves is a longest curve portion. Below, in the vertical section, if the side-wall outer surface 123a includes a single arc-shaped curve, this arc-shaped curve is referred to as "main arc". In the vertical section, if the side-wall outer surface 123a includes a plurality of arc-shaped curves, a longest curve among the plurality of arc-shaped curves is referred to as "main arc". In the same and/or similar manner, in the vertical section, if the side-wall inner surface 123b includes a single arc-shaped curve, this arc-shaped curve is referred to as "main arc". In the vertical section, if the side-wall inner surface 123b includes a plurality of arc-shaped curves, a longest curve among the plurality of arc-shaped curves is referred to as "main arc".

(Embodiments 6 and 7)

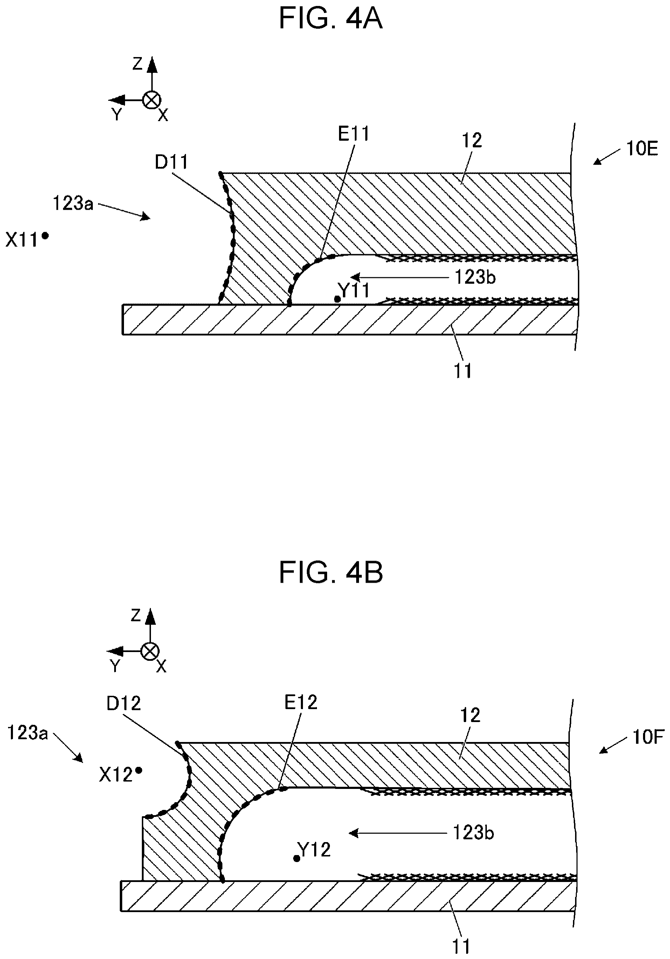

FIGs. 4A and 4B are vertical sectional views of side wall parts of heat dissipation members respectively according to Embodiments 6 and 7. Heat dissipation members 10E and 10F in Embodiments 6 and 7 may be the same as and/or similar to that in Embodiment 1 except for difference in a shape of the side wall part 123. Each of the heat dissipation members 10E and 10F in Embodiments 6 and 7 may be included in a vapor chamber in the same and/or similar manner as or to Embodiment 1.

As illustrated in FIG. 4A, a main arc D11 of the side-wall outer surface 123a may have a radius larger than a radius of a main arc E11 of the side-wall inner surface 123b. FIG. 4B, in contrast, illustrates an example, in which a main arc D12 of the side-wall outer surface 123a has a radius smaller than a radius of a main arc E12 of the side-wall inner surface 123b. Points X11 and X12 are center points of the respective ones of the main arcs D11 and D12. Points Y11 and Y12 are center points of the respective ones of the main arcs E11 and E12. With the configuration illustrated in FIG. 4A, the side-wall outer surface 123a can have an increased surface area at the narrowed portion. Therefore, heat dissipation from the narrowed portion of the side-wall outer surface 123a improves. Accordingly, an action to improve fluidity of liquid-phase fluid at the side-wall inner surface 123b can be reinforced.

The same and/or similar is applicable even if one or both of the side-wall outer surface 123a and the side-wall inner surface 123b includes a plurality of arc-shaped curves in the vertical section.

(Embodiments 8 and 9)

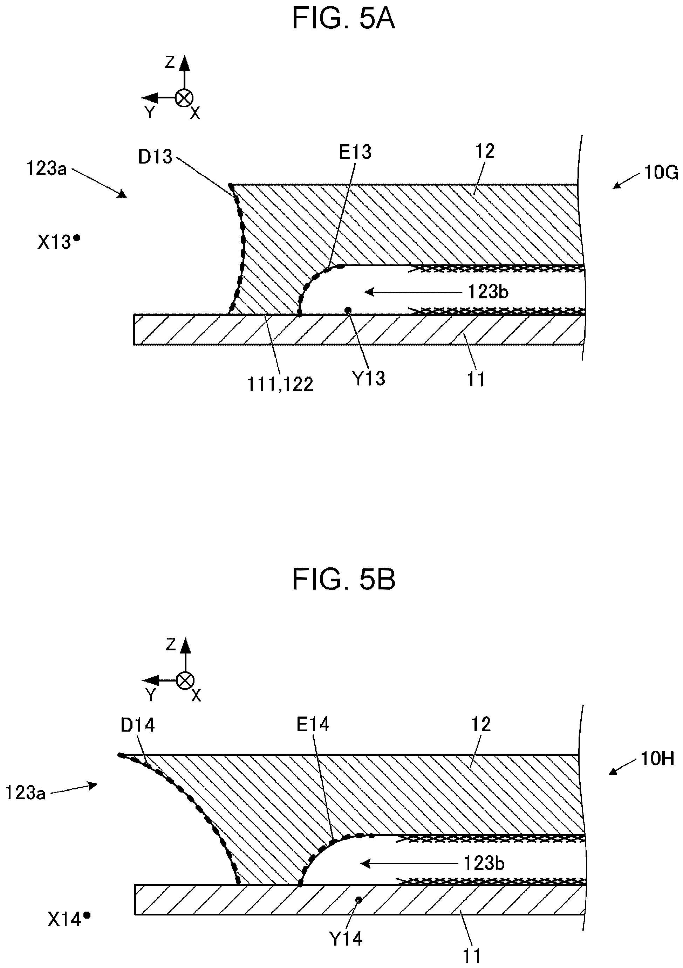

FIGs. 5A and 5B are vertical sectional views of side wall parts of heat dissipation members respectively according to Embodiments 8 and 9. Heat dissipation members 10G and 10H in Embodiments 8 and 9 may be the same as and/or similar to that in Embodiment 1 except for difference in a shape of the side wall part 123. Each of the heat dissipation members 10G and 10H in Embodiments 8 and 9 may be included in a vapor chamber in the same and/or similar manner as or to Embodiment 1.

As illustrated in FIG. 5A, a center point X13 of a main arc D13 of the side-wall outer surface 123a and a center point Y13 of a main arc E13 of the side-wall inner surface 123b may be positioned higher than the first surface 111 (that is, at a height closer to the housing 12). FIG. 5B, in contrast, illustrates an example in which a center point X14 of a main arc D14 of the side-wall outer surface 123a is positioned lower than the first surface 111, and a center point Y14 of a main arc E14 of the side-wall inner surface 123b is positioned lower than the first surface 111. With the configuration illustrated in FIG. 5A, the side wall part 123 includes the narrowed portion at an intermediate portion of the main arc D13, E13. Therefore, the side-wall outer surface 123a can have further improved heat dissipation capacity at the narrowed portion, and an action to improve fluidity of liquid-phase fluid at the side-wall inner surface 123b can be further reinforced.

The same and/or similar is applicable even if one or both of the side-wall outer surface 123a and the side-wall inner surface 123b includes a plurality of arc-shaped curves in the vertical section.

(Embodiments 10 to 14)

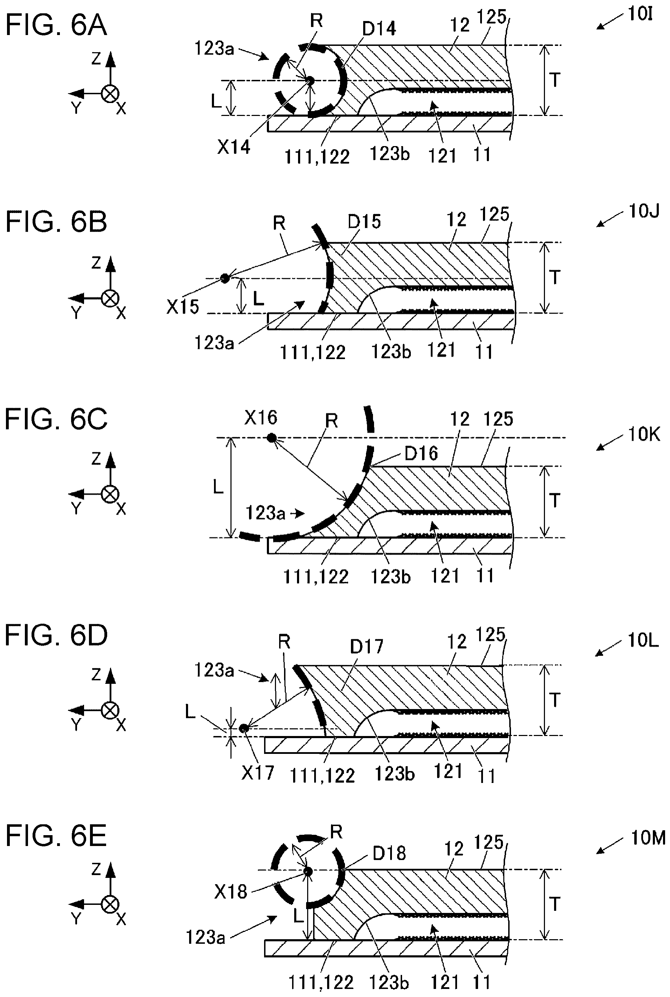

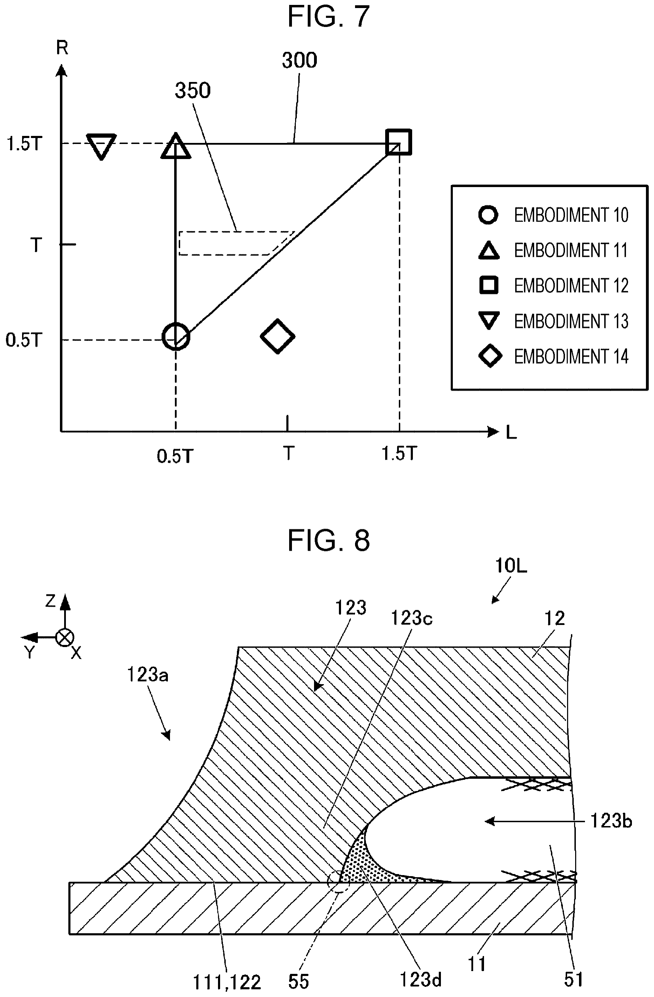

FIGs. 6A to 6E are vertical sectional views of side wall parts of heat dissipation members respectively according to Embodiments 10 to 14. FIG. 7 is a graph illustrating values of parameters of the heat dissipation members according to Embodiments 10 to 14. Heat dissipation members 10I to 10M in Embodiments 10 to 14 may be the same as and/or similar to that in Embodiment 1 except for difference in a shape of the side wall part 123. Each of the heat dissipation members 10I to 10M in Embodiments 10 to 14 may be included in a vapor chamber in the same and/or similar manner as or to Embodiment 1.

As illustrated in FIGs. 6A to 6C, if a height from the opening end of the recess 121 to the external top surface (corresponding to the third surface) 125 of the housing 12 is referred to as a thickness T of the housing 12, a center-point height L and a radius R of a main arc D14-D16 of the side-wall outer surface 123a may satisfy the following Condition 1. The center-point height L is a distance between a center point X14-X16 of the main arc D14-D16 of the side-wall outer surface 123a and an extended plane of the second surface 122.

<Condition 1>
$$0.5 \times T \geq R \geq 1.5 \times T$$
$$0.5 \times T \geq L \geq 1.5 \times T$$
$$R \geq L$$

Specifically, the center-point height L and the radius R in each of Embodiments 10 to 12 are as follows.

Embodiment 10 (see FIG. 6A): R = 0.5 × T, L = 0.5 × T
Embodiment 11 (see FIG. 6B): R = 1.5 × T, L = 0.5 × T
Embodiment 12 (see FIG. 6C): R = 1.5 × T, L = 1.5 × T

FIGs. 6D and 6E illustrate examples that do not meet Condition 1. Specifically, the center-point height L and the radius R in each of Embodiments 13 and 14 are as follows.

Embodiment 13 (see FIG. 6D): R = 1.5 × T, L = 0.2 × T
Embodiment 14 (see FIG. 6E): R = 0.5 × T, L = 1.0 × T

If Condition 1 is satisfied, as can be seen in comparison between FIGs. 6A to 6C and FIG. 6E, a single, arc-shaped curved surface can take up a high rate of the side-wall outer surface 123a. Therefore, in transparent plan view, the narrowed portion can be positioned on an inner side of an end of the housing 12. Further, as can be seen in comparison between FIGs. 6A to 6C and FIG. 6D, the side wall part 123 can have a widen-base shape. Therefore, while heat dissipation at the narrowed portion is secured, the second surface 122 can have a wider width. The wider width of the second surface 122 increases a bonding area between the substrate 11 and the housing 12, which can improve bonding reliability.

Condition 1 means that, in the graph in FIG. 7, the parameters R and L are positioned on a triangular area 300. Note that the center-point height L and the radius R may satisfy, in addition to Condition 1, the following Condition 2.

<Condition 2>
$$0.9 \times T \leq R \leq 1.1 \times T$$

Satisfying both of Condition 1 and Condition 2 means that, in the graph in FIG. 7, the parameters R and L are positioned on an area 350.

Satisfaction of Condition 1 and Condition 2 can further improve ease of manufacture of the side wall part 123 of the housing 12.

(Embodiment 15)

FIG. 8 is a vertical sectional view of a side wall part of a heat dissipation member according to Embodiment 15. A heat dissipation member 10L in Embodiment 15 may be the same as and/or similar to that in Embodiment 1 except for difference in a structure of the side-wall inner surface 123b. The heat dissipation member 10L in Embodiment 15 may be included in a vapor chamber in the same and/or similar manner as or to Embodiment 1.

In the heat dissipation member 10L in Embodiment 15, a surface of the side-wall inner surface 123b may include a film part 123d containing a constituent (for example, silver (Ag)) with thermal conductivity higher than that of a material (for example, Cu (copper)) for a side-wall internal portion 123c. That is, the film part 123d with the thermal conductivity of the film part 123d may be formed by a partial constituent of the brazing material bonding the housing 12 and the substrate 11 to one another being extracted. The brazing material may be a silver copper (AgCu) brazing material.

With such a configuration, even if a member of the side-wall internal portion 123c includes a structural portion (for example, a recess with a recess angle of 90°or less, or a groove) where liquid-phase fluid easily stagnates, the film part 123d can fill the structural portion to reduce stagnation of liquid-phase fluid.

The space 51 of the heat dissipation member 10L includes a portion where increase and decrease of a heat amount is drastic due to repetitive vaporization and condensation of fluid. On the other hand, the film part 123d with high thermal conductivity improves horizontal conductivity of heat via the film part 123d. Therefore, a fluctuation action of heat from the portion where increase and decrease of a heat amount is drastic can be led to the side-wall inner surface 123b via the film part 123d. Such an action can improve fluidity of liquid-phase fluid at the side-wall inner surface 123b. Thereby, liquid-phase fluid can be less likely to stagnate at the side-wall inner surface 123b, and the heat dissipation member 10L can have further improved heat dissipation capacity.

The film part 123d may have a thickness increasing toward the second surface 122. With such a configuration, the film part 123d can smoothen a recess angle 55 formed between a member of the side-wall internal portion 123c and the substrate 11. Therefore, liquid-phase fluid can have further improved fluidity at this portion. In addition, a contact area between the substrate 11 and the film part 123d increases, and a heat dissipation action at the substrate 11 affects the film part 123d. This action reinforces a fluctuation action of heat at the film part 123d, and liquid-phase fluid can have further improved fluidity at the side-wall inner surface 123b.

(Embodiment 16)

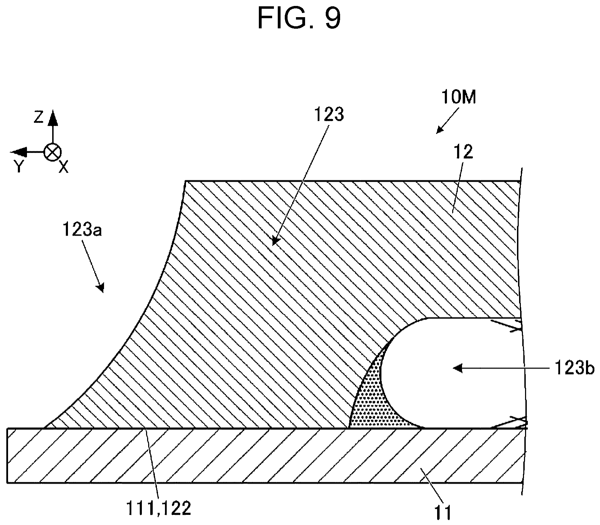

FIG. 9 is a vertical sectional view of a side wall part of a heat dissipation member according to Embodiment 16. A heat dissipation member 10M in Embodiment 15 may be the same as and/or similar to that in Embodiment 1 except for difference in a shape of the side-wall inner surface 123b. The heat dissipation member 10M in Embodiment 16 may be included in a vapor chamber in the same and/or similar manner as or to Embodiment 1.
In the heat dissipation member 10M in Embodiment 16, the side-wall inner surface 123b may have a semicircular shape in the vertical section. The semicircular shape means a curved shape with an error with respect to a semicircle at 5% or less of a diameter of the semicircle. With such a configuration, liquid-phase fluid can be further less likely to stagnate at the side-wall inner surface 123b. Therefore, liquid-phase fluid has improved fluidity, and the heat dissipation member 10M can have further improved heat dissipation capacity.
If a heating medium that serves as gas-phase fluid and liquid-phase fluid is water, upon freezing of liquid-phase fluid at a stagnation portion, the freezing causes expansion of volume of the heating medium. If the freezing occurs while liquid-phase fluid collects over an entire region of the side-wall inner surface 123b in a vertical direction, force to separate the housing 12 and the substrate 11 from one another occurs. However, with the above-described configuration, if the heat dissipation member 10M is not in use (that is, conduction of heat from a heat source is absent), liquid-phase fluid can be less likely to collect over the entire region of the side-wall inner surface 123b in the vertical direction. Therefore, the above-described problem in freezing may be reduced.

(Embodiments 17 and 18)

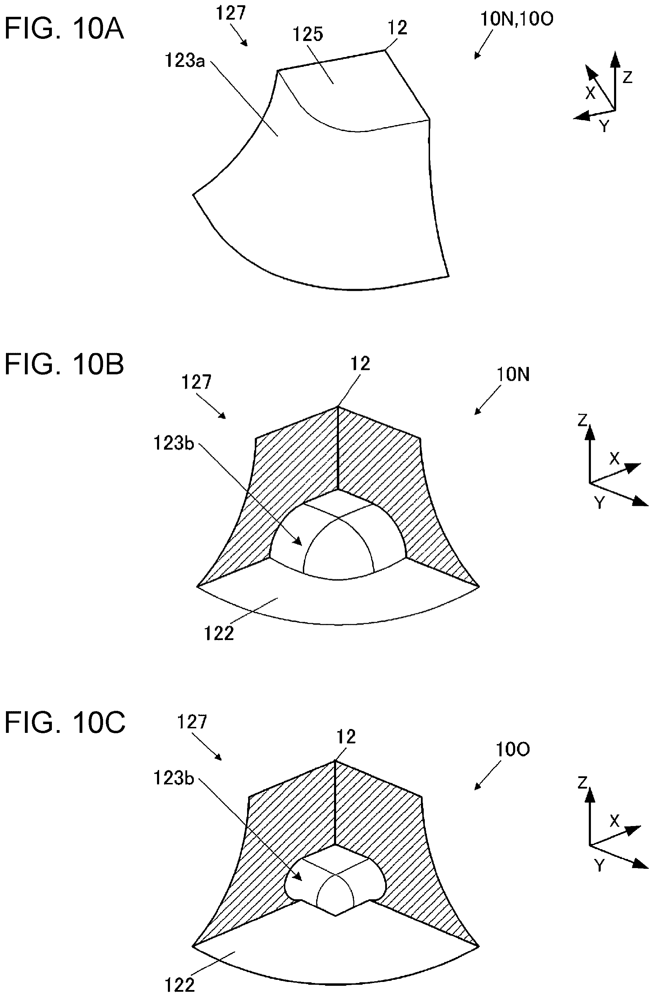

FIG. 10A is a perspective view of a part of interest, illustrating a corner-part outer side of a housing according to Embodiments 17 and 18. FIG. 10B is a perspective view including a vertical section of a part of interest, illustrating a corner-part inner side of the housing according to Embodiment 17. FIG. 10C is a perspective view including a vertical section of a part of interest, illustrating a corner-part inner side of the housing according to Embodiment 18. FIGs. 10A to 10C illustrate cut views of a corner part 127 of the housing 12 in plan view (see FIG. 1B). A surface indicated by hatching in FIGs. 10B and 10C is a cut surface, and is a surface cut in the vertical direction. Heat dissipation members 10N and 10O in Embodiments 17 and 18 may be the same as and/or similar to that in Embodiment 1 except for difference in a shape of the corner part 127. Each of the heat dissipation members 10N and 10O in Embodiments 17 and 18 may be included in a vapor chamber in the same and/or similar manner as or to Embodiment 1.
In the heat dissipation members 10N and 10O in Embodiments 17 and 18, as illustrated in FIG. 10A, the side-wall outer surface 123a at the corner part 127 may have a skirt-like shape (that is, a widen-base shape). With such a configuration, an area ratio of the side-wall outer surface 123a to the side-wall inner surface 123b at the corner part 127 can be extremely high. Moreover, high fluidity of outside air along the side-wall outer surface 123a can be maintained. Therefore, heat dissipation from the side-wall inner surface 123b to the side-wall outer surface 123a at the corner part 127 can be comparatively large as compared with a region other than the corner part 127. Accordingly, a heat dissipation amount has a gradient between the corner part 127 and a region adjacent to the corner part 127, and this gradient facilitates transfer of liquid-phase fluid. Therefore, liquid-phase fluid at the side-wall inner surface 123b can have improved fluidity at the corner part 127, and liquid-phase fluid can be less likely to stagnate at the side-wall inner surface 123b.
As illustrated in FIG. 10B, in the heat dissipation member 10N in Embodiment 17, the side-wall inner surface 123b may have an 1/8 sphere-surface shape at the corner part 127. The sphere-surface shape means a curved shape with an error with respect to a surface of a sphere at 5% or less of a diameter of the sphere. A 1/4 sphere surface means one of surfaces obtained through quartering of a sphere surface along one center axis. A 1/8 sphere surface means one of surfaces obtained through halving of a 1/4 sphere surface further along a plane perpendicular to the above-described center axis. With such a configuration, the side-wall inner surface 123b of the corner part 127 is smooth. Therefore, liquid-phase fluid can have improved fluidity at this portion, and liquid-phase fluid can be less likely to stagnate at this portion. Accordingly, the heat dissipation member 10O can have improved heat dissipation capacity.
As illustrated in FIG. 10C, in the heat dissipation member 10O in Embodiment 18, the side-wall inner surface 123b may have a 1/4 sphere-surface shape at the corner part 127. With such a configuration, a smooth surface continues from the internal top surface 124 to the internal bottom surface 112 of the space 51 with the side-wall inner surface 123b of the corner part 127 interposed therebetween. Therefore, liquid-phase fluid can have improved fluidity at this portion, and liquid-phase fluid can be further less likely to stagnate at this portion. Accordingly, the heat dissipation member 10N can have improved heat dissipation capacity.

With the above-described configuration, if the heat dissipation member 10O is not in use (that is, conduction of heat from a heat source is absent), liquid-phase fluid can be less likely to collect over an entire region of the side-wall inner surface 123b at the corner part 127 in the vertical direction. Therefore, force to separate the substrate 11 and the housing 12 from one another can be less likely to occur by freezing at the corner part 127.

Each embodiment of the present disclosure has been described above. However, the heat dissipation member and the vapor chamber of the present disclosure are not limited to those in the embodiments described above. A characteristic part of one embodiment may be combined with a characteristic part of another embodiment as long as they are not contradictory to one another.

Below, an embodiment of the present disclosure is described. In an embodiment, (1) a heat dissipation member includes a substrate including a first surface; and a housing including a recess and a second surface positioned around an opening end of the recess, wherein the second surface is bonded to the first surface, the recess includes, inside the recess, a space surrounded by the housing and the substrate, in the vertical section, a side-wall inner surface of the space has a recessed, curved shape, and a side-wall outer surface of the housing has a recessed, curved shape, and in the vertical section, a recessed direction of the side-wall inner surface and a recessed direction of the side-wall outer surface are opposed to one another.

(2) In the heat dissipation member of (1), in the vertical section, one end, closer to the side-wall inner surface, of a line segment is positioned away from both ends of the side-wall inner surface, and an other end, closer to the side-wall outer surface, of the line segment is positioned away from both ends of the side-wall outer surface, the line segment connecting the side-wall inner surface and the side-wall outer surface with a shortest line.

(3) In the heat dissipation member of (1) or (2), in the vertical section, the side-wall inner surface has a shape including one arc-shaped curve or a plurality of arc-shaped curves combined, and in the vertical section, the side-wall outer surface has a shape including one arc-shaped curve or a plurality of arc-shaped curves combined.

(4) In the heat dissipation member of (3), if the one arc-shaped curve, or a longest curve among the plurality of arc-shaped curves is referred to as a main arc, in the vertical section, a radius of the main arc of the side-wall outer surface is longer than a radius of the main arc of the side-wall inner surface.

(5) In the heat dissipation member of (3), if the one arc-shaped curve, or a longest curve among the plurality of arc-shaped curves is referred to as a main arc, in the vertical section, a center point of the main arc of the side-wall outer surface and a center point of the main arc of the side-wall inner surface are positioned at a height closer to the housing with respect to the first surface.

(6) In the heat dissipation member of any of (1) to (5), the housing includes a third surface on an opposite side to the recess, and if a height from the opening end of the recess to the third surface is referred to as a thickness T of the housing, the one arc-shaped curve, or a longest curve among the plurality of arc-shaped curves is referred to as a main arc, and a distance between a center point of the main arc of the side-wall outer surface and an extended plane of the second surface is referred to as a center-point height L, a radius R of the main arc of the side-wall outer surface is 0.5 times or more and 1.5 times or less the thickness T, the center-point height L is 0.5 times or more and 1.5 times or less the thickness T, and the radius R is equal to or greater than the center-point height L.

(7) The heat dissipation member of any of (1) to (6) includes a film part positioned at the side-wall inner surface, wherein the film part has thermal conductivity higher than thermal conductivity of a side-wall internal portion.

(8) In the heat dissipation member of (7), the film part has a thickness increasing toward the second surface.

(9) In the heat dissipation member of any of (1) to (8), in the vertical section, the side-wall inner surface has a semicircular shape.

(10) In the heat dissipation member of any of (1) to (9), the housing includes a corner part in plan view, the side-wall outer surface at the corner part has a skirt-like shape widening toward the second surface, and the side-wall inner surface at the corner part is a recessed, curved surface in a sphere-surface shape.

In an embodiment, (11) a vapor chamber includes the heat dissipation member of any of (1) to (10); and liquid-phase fluid in the space.

INDUSTRIAL APPLICABILITY

The present disclosure is applicable to a heat dissipation member and a vapor chamber.

REFERENCE SIGNS

> 10, 10A-10O heat dissipation member
> 11 substrate
> 111 first surface
> 112 internal bottom surface
> 12 housing
> 121 recess
> 122 second surface
> 123 side wall part

123a side-wall outer surface
123b side-wall inner surface
123c side-wall internal portion
123d film part
124 internal top surface
125 external top surface (third surface)
127 corner part
50 vapor chamber
51 space
52 void structure
55 recess angle
A1, B1 recessed direction
C1 line segment
D1-D9, E1-E9 arc-shaped curve
D11-D16, E11-E13 main arc
L center-point height
R radius
T housing thickness

**Claims**

1.  A heat dissipation member comprising:

    a substrate comprising a first surface; and
    a housing comprising a recess and a second surface positioned around an opening end of the recess, wherein
    the second surface is bonded to the first surface,
    the recess comprises, inside the recess, a space surrounded by the housing and the substrate,
    in the vertical section, a side-wall inner surface of the space has a recessed, curved shape, and a side-wall outer surface of the housing has a recessed, curved shape, and
    in the vertical section, a recessed direction of the side-wall inner surface and a recessed direction of the side-wall outer surface are opposed to one another.

2.  The heat dissipation member according to claim 1, wherein, in the vertical section, one end, closer to the side-wall inner surface, of a line segment is positioned away from both ends of the side-wall inner surface, and an other end, closer to the side-wall outer surface, of the line segment is positioned away from both ends of the side-wall outer surface, the line segment connecting the side-wall inner surface and the side-wall outer surface with a shortest line.

3.  The heat dissipation member according to claim 1 or 2, wherein, in the vertical section, the side-wall inner surface has a shape comprising one arc-shaped curve or a plurality of arc-shaped curves combined, and
    in the vertical section, the side-wall outer surface has a shape comprising one arc-shaped curve or a plurality of arc-shaped curves combined.

4.  The heat dissipation member according to claim 3, wherein if the one arc-shaped curve, or a longest curve among the plurality of arc-shaped curves is referred to as a main arc,
    in the vertical section, a radius of the main arc of the side-wall outer surface is longer than a radius of the main arc of the side-wall inner surface.

5.  The heat dissipation member according to claim 3, wherein if the one arc-shaped curve, or a longest curve among the plurality of arc-shaped curves is referred to as a main arc,
    in the vertical section, a center point of the main arc of the side-wall outer surface and a center point of the main arc of the side-wall inner surface are positioned at a height closer to the housing with respect to the first surface.

6.  The heat dissipation member according to any one of claims 3 to 5, wherein the housing comprises a third surface on an opposite side to the recess, and

    if a height from the opening end of the recess to the third surface is referred to as a thickness T of the housing,
    the one arc-shaped curve, or a longest curve among the plurality of arc-shaped curves is referred to as a main arc, and
    a distance between a center point of the main arc of the side-wall outer surface and an extended plane of the second surface is referred to as a center-point height L,

    a radius R of the main arc of the side-wall outer surface is 0.5 times or more and 1.5 times or less the thickness T,
    the center-point height L is 0.5 times or more and 1.5 times or less the thickness T, and
    the radius R is equal to or greater than the center-point height L.

7.  The heat dissipation member according to any one of claims 1 to 6, comprising a film part positioned at the side-wall inner surface, wherein
    the film part has thermal conductivity higher than thermal conductivity of a side-wall internal portion.

8.  The heat dissipation member according to claim 7, wherein the film part has a thickness increasing toward the second surface.

9.  The heat dissipation member according to any one of claims 1 to 8, wherein, in the vertical section, the side-wall inner surface has a semicircular shape.

10. The heat dissipation member according to any one of claims 1 to 9, wherein the housing comprises a corner part in plan view,

the side-wall outer surface at the corner part has a skirt-like shape widening toward the second surface, and
the side-wall inner surface at the corner part is a recessed, curved surface in a sphere-surface shape.

**11.** A vapor chamber comprising:

the heat dissipation member according to any one of claims 1 to 10; and
liquid-phase fluid in the space.

# FIG. 1A

# FIG. 1B

# FIG. 2

## FIG. 3A

## FIG. 3B

## FIG. 3C

## FIG. 3D

# FIG. 4A

# FIG. 4B

# FIG. 5A

# FIG. 5B

FIG. 6A

Z
Y ⊗ X

10I

123a

R    D14    12  125

L

X14

111,122  123b  121  11

T

FIG. 6B

Z
Y ⊗ X

10J

R    D15    12  125

X15

L

123a

111,122  123b  121  11

T

FIG. 6C

Z
Y ⊗ X

10K

X16    R    12  125

D16

L

123a→

111,122  123b  121  11

T

FIG. 6D

Z
Y ⊗ X

10L

123a

R    D17    12  125

L

X17  111,122  123b  121  11

T

FIG. 6E

Z
Y ⊗ X

10M

R

D18    12  125

X18

L

123a

111,122  123b  121  11

T

# FIG. 7

# FIG. 8

# FIG. 9

FIG. 10A

FIG. 10B

FIG. 10C

## INTERNATIONAL SEARCH REPORT

| International application No. |
| --- |
| **PCT/JP2024/006484** |

**A.    CLASSIFICATION OF SUBJECT MATTER**

*F28D 15/02*(2006.01)i; *H01L 23/427*(2006.01)i; *H05K 7/20*(2006.01)i
FI:    F28D15/02 101H; F28D15/02 102H; H01L23/46 B; H05K7/20 Q

According to International Patent Classification (IPC) or to both national classification and IPC

**B.    FIELDS SEARCHED**

Minimum documentation searched (classification system followed by classification symbols)

F28D15/02; H01L23/427; H05K7/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| X | WO 2022/176985 A1 (DAI NIPPON PRINTING CO., LTD.) 25 August 2022 (2022-08-25) paragraphs [0259]-[0371], [0417], [0418], fig. 36, 52, 58 | 1-4, 9, 11 |
| Y |  | 7-9, 11 |
| A |  | 5-6, 10 |
| Y | JP 2020-28895 A (UACJ CORP.) 27 February 2020 (2020-02-27) paragraphs [0078]-[0086], fig. 1, 2, 5 | 7-9, 11 |
| Y | JP 2017-172871 A (KABUSHIKI KAISHA KOBE SEIKO SHO) 28 September 2017 (2017-09-28) paragraphs [0005]-[0009], fig. 1 | 7-9, 11 |

☐ Further documents are listed in the continuation of Box C.        ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **26 April 2024** | **14 May 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/006484**

| Patent document cited in search report | | | Publication date (day/month/year) | Patent family member(s) | | | Publication date (day/month/year) |
|---|---|---|---|---|---|---|---|
| WO | 2022/176985 | A1 | 25 August 2022 | CN | 116964400 | A | |
| | | | | KR | 10-2023-0146587 | A | |
| | | | | TW | 202238058 | A | |
| JP | 2020-28895 | A | 27 February 2020 | (Family: none) | | | |
| JP | 2017-172871 | A | 28 September 2017 | WO | 2017/164013 | A1 | |
| | | | | CN | 108885067 | A | |
| | | | | KR | 10-2018-0122001 | A | |
| | | | | TW | 201802249 | A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003254685 A